Europäisches Patentamt

European Patent Office

Office européen des brevets

(19)

(11) EP 0 628 828 B1

(12) FASCICULE DE BREVET EUROPEEN

(45) Date de publication et mention
de la délivrance du brevet:
**14.04.1999 Bulletin 1999/15**

(51) Int Cl.⁶: **G01R 21/133**

(21) Numéro de dépôt: **94410041.1**

(22) Date de dépôt: **08.06.1994**

(54) **Dispositif de mesure et de comptage d'énergie électrique**

Mess- und Zählvorrichtung für elektrische Energie

Appliance for measuring and counting electrical energy

(84) Etats contractants désignés:
**DE ES GB IT**

(30) Priorité: **11.06.1993 FR 9307161**

(43) Date de publication de la demande:
**14.12.1994 Bulletin 1994/50**

(73) Titulaire: **MGE-UPS SYSTEMS**
**38240 Meylan (FR)**

(72) Inventeurs:
 • **Pillet, Jean-Jacques**
 **F-38050 Grenoble Cédex 09 (FR)**
 • **Fiorina, Jean-Noel**
 **F-38050 Grenoble Cedex 09 (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
 • **PATENT ABSTRACTS OF JAPAN vol. 15, no. 433**
 **(P-1271) 5 Novembre 1991 & JP-A-03 180 770**
 **(MEIDENSHA) 6 Août 1991**

## Description

L'invention concerne un dispositif de mesure et de comptage de l'énergie électrique consommée par une installation, dispositif comportant des moyens de mesure d'au moins un courant consommé par l'installation, des moyens de mesure d'au moins une tension associée appliquée à l'installation, un compteur d'énergie électrique standard fonctionnant en courant alternatif et comportant des entrées de courant et de tension.

Les compteurs d'énergie électrique standards fonctionnent en courant alternatif, typiquement à 50 ou 60 Hz. Ils ne peuvent pas être utilisés directement pour le comptage de l'énergie électrique consommée par une installation alimentée en courant continu ou en courant alternatif de fréquence, par exemple 400 Hz, différente de celle pour laquelle est prévu le compteur alternatif standard.

Dans certains réseaux de distribution d'énergie électrique, il a été proposé (EP-A-550348) d'alimenter des utilisateurs à partir d'un bus de distribution d'énergie continue, le courant continu étant obtenu à partir du réseau alternatif au moyen d'un module central de conversion alternatif continu. Bien entendu, le comptage d'énergie peut être effectué en amont du module central au moyen d'un compteur alternatif standard. Cependant, lorsque les installations alimentées par le bus sont indépendantes et correspondent à des utilisateurs différents, il est souhaitable de disposer de dispositifs de comptage de l'énergie électrique associés à chacune des installations. Ces dispositifs doivent fonctionner en courant continu et être homologués et qualifiés par des distributeurs de courant et par des organismes de qualification pour pouvoir servir à la tarification et à la facturation de l'énergie consommée.

Bien qu'il existe des dispositifs de comptage électrique entièrement électroniques permettant d'effectuer une mesure d'énergie, aussi bien en continu qu'en alternatif, ces dispositifs ne sont pas actuellement homologués ou doivent suivre un cycle de qualification très long, de sorte qu'ils ne peuvent être utilisés à court terme pour servir à la facturation de l'énergie consommée.

L'invention a pour but un dispositif de comptage de l'énergie électrique, utilisant un compteur alternatif standard et permettant de fournir un comptage de l'énergie consommée par une installation alimentée en courant continu ou en courant alternatif de fréquence différente de celle pour laquelle est prévu le compteur alternatif standard. Un tel dispositif pourra être utilisé pour servir à la facturation sans nécessiter une nouvelle homologation.

Selon l'invention, ce but est atteint par le fait que le dispositif comporte des moyens de conversion connectés entre les moyens de mesure et le compteur standard, et comportant des moyens de production de signaux alternatifs de courant et de tension de sortie adaptés au compteur standard, la puissance, représentée par les signaux alternatifs de courant et de tension fournis par le convertisseur, étant proportionnelle à la puissance électrique correspondant aux courants et tensions mesurés par les moyens de mesure.

Selon un développement de l'invention, les moyens de mesure fournissent des premiers couples de signaux de tension et de courant, les moyens de conversion fournissant au compteur des seconds couples de signaux de tension et de courant alternatifs tels que la puissance correspondant à la somme des produits tension-courant des seconds couples de signaux soit proportionnelle à la puissance correspondant à la somme des produits tension-courant des premiers couples de signaux.

Les moyens de conversion comportent des moyens de contrôle et de modulation de l'amplitude des signaux alternatifs de sortie des moyens de conversion en fonction des valeurs des signaux de sortie des moyens de mesure, ou en fonction de la puissance associée à au moins un signal de courant et un signal de tension associé fourni par les moyens de mesure.

Selon un mode de réalisation préférentiel, les moyens de conversion comportent des moyens d'amplification des signaux alternatifs représentatifs des tensions de sortie fournissant des tensions de sortie d'amplitude compatible avec les niveaux du compteur et des moyens de conversion tension-courant convertissant les signaux alternatifs représentatifs des courants de sortie en courants compatibles avec les caractéristiques du compteur.

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

La figure 1 représente un réseau de distribution de courant continu comportant des dispositifs de comptage d'énergie selon l'invention.

La figure 2 représente, sous forme de schéma-bloc, un dispositif de comptage selon l'invention, pouvant être utilisé avec un réseau de distribution de courant continu selon la figure 1.

La figure 3 représente sous forme de schéma-bloc, un premier mode de réalisation particulier d'un circuit de conversion du dispositif selon la figure 2.

Les figures 4a à 4e illustrent respectivement les variations des signaux d'entrée 4a,4b, de sortie 4c,4d ainsi que l'énergie mesurée par un dispositif de comptage comportant un circuit de conversion selon la figure 3.

La figure 5 représente sous forme de schéma-bloc, un autre mode de réalisation d'un circuit de conversion selon la figure 2.

La figure 6 représente un organigramme partiel du programme du microprocesseur dans une variante du circuit selon la figure 5.

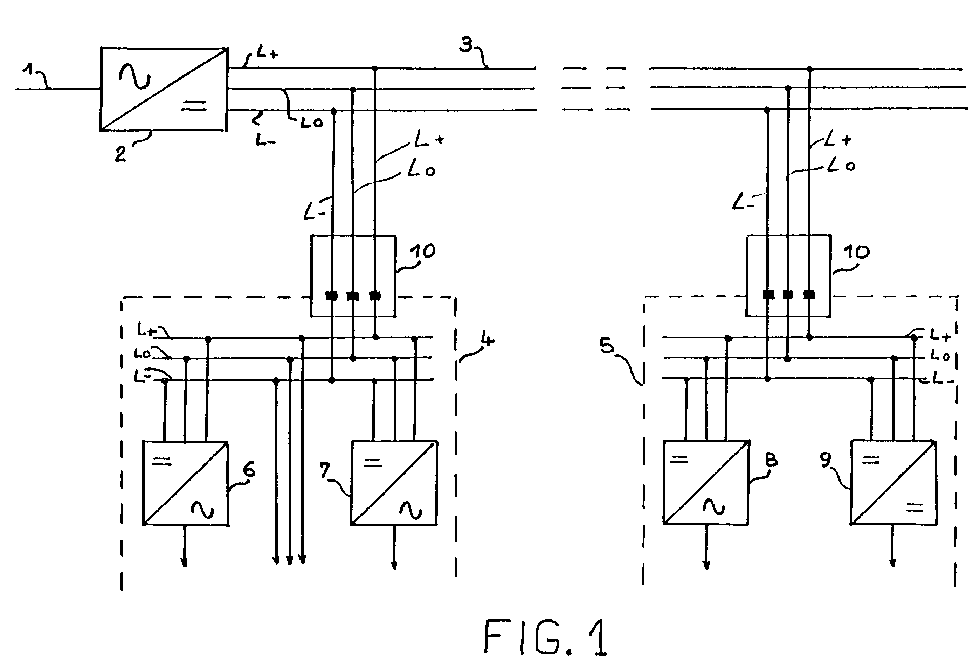

Sur la figure 1 une ligne 1 d'alimentation en courant alternatif (50 ou 60 Hz) est connectée à l'entrée d'un convertisseur de courant 2 alternatif continu. Le courant continu présent en sortie du convertisseur est fourni à un réseau ou bus de distribution 3 qui alimente en continu des installations 4 et 5. Dans le mode de réalisation représenté, le réseau de distribution 3 comporte un premier conducteur L+ dans lequel circule un courant I+, un second conducteur L- dans lequel circule un courant I-, et un conducteur commun L0. Chaque installation, 4 ou 5, comporte des convertisseurs continu-alternatif 6, 7, 8 ou continu-continu 9 pour l'alimentation d'appareils devant être alimentés en courant alternatif ou en courant continu.

Sur la figure 1 un dispositif de comptage 10 selon l'invention est connecté à l'entrée de chacune des installations 4 et 5 connectée au bus 3, afin de permettre de compter séparément l'énergie consommée par chacune de ces installations.

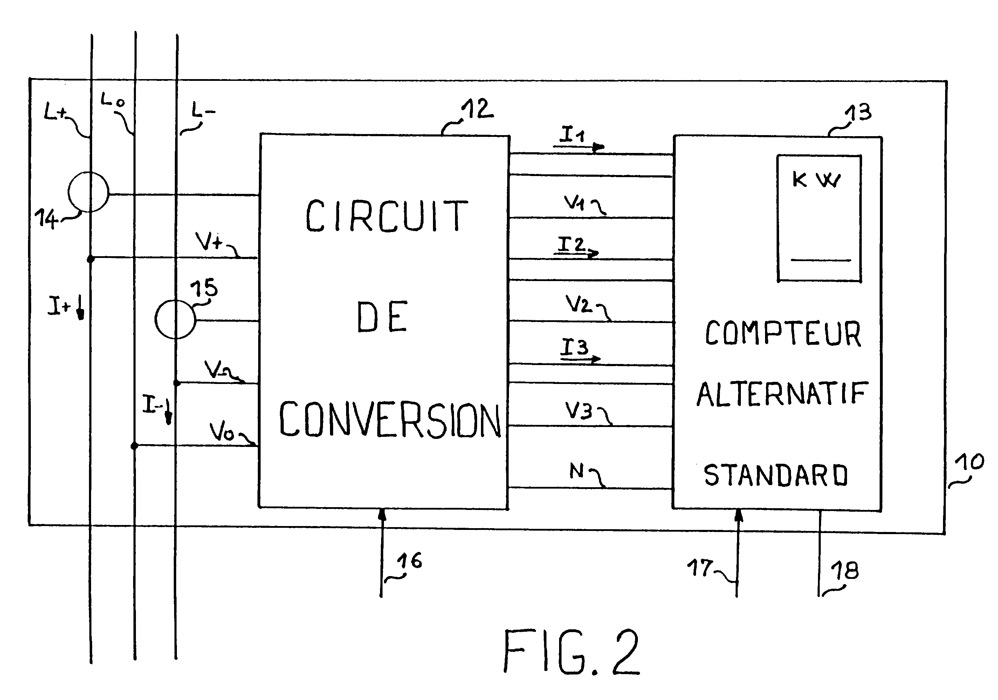

La figure 2 représente un mode de réalisation d'un dispositif de comptage 10 destiné à être utilisé dans le réseau à courant continu de la figure 1. Le dispositif de comptage 10 comporte un circuit de conversion 12 et un compteur 13 d'énergie électrique alternative standard de type connu.

Dans le mode de réalisation représenté sur la figure 2, le compteur 13 est un compteur alternatif standard triphasé. n comporte des entrées destinées à recevoir des signaux (V1, V2, V3, I1, I2, I3) représentatifs des tensions et des courants des trois phases d'un réseau alternatif. Sur la figure, trois entrées de courant sont constituées chacune de deux conducteurs normalement destinées à être connectées à la sortie de capteurs de courant disposés respectivement sur les trois phases d'un réseau alternatif. Les entrées de tension sont constituées par quatre conducteurs destinées normalement à être connectées à chacun des conducteurs de phase et au conducteur de neutre N d'un réseau alternatif. L'énergie W1 fournie au compteur 13 est obtenue à partir des signaux V1, V2 et V3 représentatifs des tensions et I1, I2, I3 représentatifs des courants conformément à l'expression (1)

$$W1 \; = \; \int_0^T [\,(V1.I1)+(V2.I2)+(V3.V2)]\,dt \qquad (1)$$

Le circuit de conversion 12 sert d'interface entre le compteur 13 et une branche du réseau 3 connectée à l'entrée de l'installation 4 ou 5 dont la consommation d'énergie doit être mesurée.

Le circuit de conversion 12 reçoit des signaux respectivement représentatifs des courants I+ et I- circulant dans les conducteurs L+ et L- et des signaux représentatifs des tensions V+ et V- mesurées respectivement entre les conducteurs L+, L- et le conducteur commun LO. Les signaux de courant I+ et I- sont fournis par des capteurs de courant respectivement 14 et 15. Les signaux de tension sont obtenus directement par connexion des entrées de tension aux conducteurs L+, L-, LO. Le conducteur commun LO fournit un signal d'entrée de référence VO.

Le convertisseur 12 transforme les signaux d'entrée I+, I-, V+ et V- en courant et tensions de sortie utilisables par le compteur alternatif standard 13.

L'énergie W2 consommée à mesurer peut s'exprimer sous la forme :

$$W2 \; = \; \int_0^T [\,(V+.I+)+(V\text{-}.I\text{-})]\,dt \qquad (2)$$

Si le convertisseur 12 fait correspondre les amplitudes des signaux continus aux valeurs des signaux alternatifs en faisant correspondre U1 à U+, U2 à U-, I1 à I+ et I2 à I- en forçant I3 à zéro, il ressort des expressions (1) et (2) ci-dessus que W1 = W2. Dans ce cas, le compteur triphasé standard 13 reçoit directement les valeurs de l'énergie à mesurer.

Cependant, une telle conversion n'est pas toujours possible directement. En effet, dans les compteurs standards les tensions d'entrée doivent être comprises entre une valeur minimale et une valeur maximale qui ne correspondent pas forcément à la gamme de tension du réseau continu. En ce qui concerne le courant, pour les installations de forte intensité le courant alternatif n'est pas directement appliqué au compteur standard. Une valeur représentative du courant à mesurer est fournie par un transformateur de courant. Généralement les compteurs sont prévus pour recevoir des valeurs maximales de l'ordre de 5A. Le rapport de transformation du transformateur de courant doit alors être conforme à la calibration du compteur pour que la valeur de l'énergie mesurée soit exacte.

En conséquence, pour s'adapter aux gammes de tension et de courant acceptables par le compteur standard 13, le convertisseur 12 réalise la conversion des signaux V+, V-, I+ et I- en signaux V1 à V3 et I1 à I3 de manière à ce que la puissance totale de sortie du convertisseur 12 soit proportionnelle, à un facteur d'échelle K connu, à la puissance totale P fournie à l'installation associée au dispositif de comptage. La puissance P peut s'exprimer sous la forme :

$$P = K\,[(V{+}.I{+}) + (V{-}.I{-})] = (V1.I1 + V2.I2 + V3.I3) \tag{3}$$

Les valeurs de signaux de courant I+, I-, I1, I2, I3 et de tension V+, V-, V1, V2, V3 sont des valeurs représentatives des courants et des tensions sur une période des signaux alternatifs, par exemple des valeurs efficaces ou moyennes. Les produits V+.I+, V1.I1, V2.I2 et V3.I3 des signaux de tension et de courant représentent des valeurs moyennes de la puissance sur une période d'intégration T. Une autre expression de la puissance en fonction de valeurs v+, i+, v-, i-, v1, i1, v2, i2, v3 et i3 représentatives des valeurs instantanées des signaux I+, V+, V-, i-, V1, I1, V2, I2, V3, I3 est donnée par l'expression 4 :

$$\mathbf{P} = \frac{1}{T}\int_0^T [\,(v1.i1) + (v2.i2) + (v3.i3)\,]\ dt\ =\ \frac{K}{T}\int_0^T [\,(v{+}.i{+}) + (v{+}.i{+})\,]\ dt \tag{4}$$

La période T d'intégration est généralement égale à la période des signaux alternatifs fournis au compteur.
A titre d'exemple, dans les expressions qui vont suivre le produit V1.I1 est aussi représentatif de la puissance moyenne

$$\frac{1}{T}\int_0^T v1.i1\ dt\ \ .$$

Un signal 16 de synchronisation peut être fourni au convertisseur 12, pour que les valeurs des tensions et des courants soient en phase avec d'autres dispositifs du réseau fonctionnant en mode alternatif. Le compteur 13 peut recevoir des commandes par une ligne 17, notamment pour le changement de tarification, ou envoyer des informations, telles que les valeurs de l'énergie électrique, par l'intermédiaire d'une ligne 18.

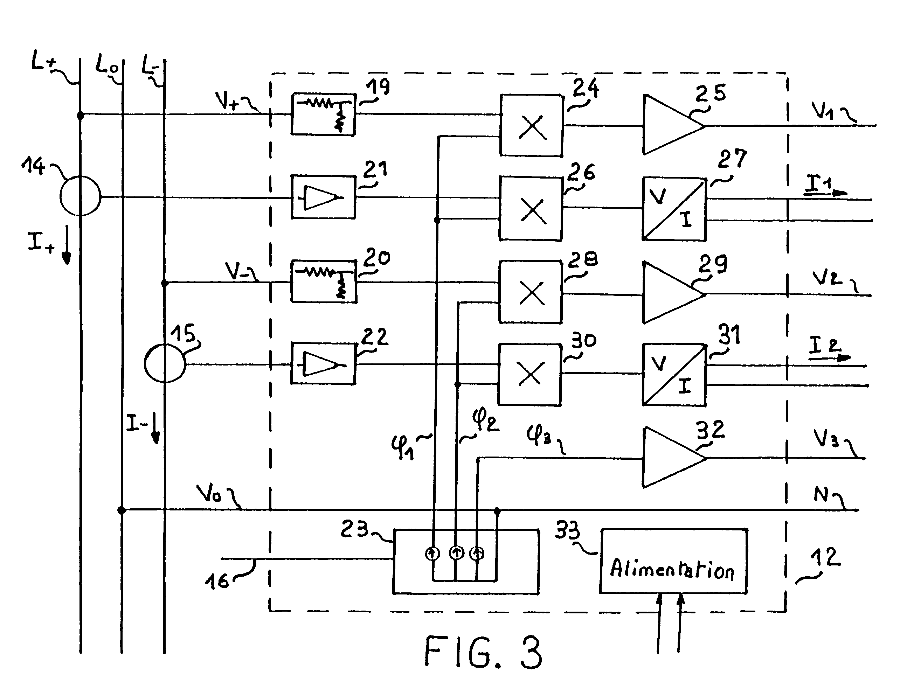

La figure 3 représente un premier mode de réalisation du convertisseur 12 de la figure 2. Le convertisseur 12 fournit trois signaux de tension triphasés V1, V2 et V3 et deux courants I1 et I2. Le courant I1 est représentatif de la valeur I+ du courant parcourant le conducteur L+ et le courant I2 est représentatif du courant I- parcourant le conducteur L-. Les tensions alternatives V1 et V2 sont respectivement représentatives des tensions continues V+ et V-. La tension V3 est indépendante des signaux d'entrée. Elle n'a pas d'effet sur le calcul de l'énergie, le courant I3 associé à la même phase étant forcé à zéro. Pour cela il suffit de laisser l'entrée correspondante du compteur 13 flottante (non connectée).
Des circuits 19 et 20 de mise à niveau, constitués par exemple par des atténuateurs, mettent les niveaux de tensions V+, V- d'entrée à des valeurs compatibles avec les circuits électroniques constituant le convertisseur 12. Pour les mêmes raisons des circuits 21 et 22 adaptent les signaux représentatifs des courants I+ et I- fournis par les capteurs de courant 14, 15.
Dans le mode de réalisation de la figure 3, un générateur 23 fournit 3 signaux alternatifs triphasés φ1, φ2 et φ3 déphasés entre eux de 120° par rapport au conducteur de neutre N, lui-même connecté directement au conducteur LO sur la figure. Le signal φ1 est modulé par la valeur représentative de la tension V+, fournie par le circuit 19, dans un multiplieur 24. Le signal alternatif de sortie du multiplieur 24 est amplifié par un amplificateur 25 pour fournir la tension alternative V1, adapté au compteur 13 et représentative de V+. Le signal φ2 est modulé par la valeur représentative du courant I+, fourni par le circuit 21, dans un multiplieur 26.
La sortie du multiplieur 26 est appliquée à l'entrée d'un convertisseur 27 tension-courant pour fournir le courant alternatif adapté au compteur 13 et représentatif de I+. La tension V1 et le courant I1 étant le résultat d'une modulation d'un même signal alternatif φ1, ils n'ont pas de déphasage et l'expression de la puissance correspondante est V1.I1. Les circuits de mise à niveau 19 et 21, l'amplificateur 25 et le convertisseur 27 sont constitués de manière à ce que la puissance de sortie V1.I1 soit proportionnelle au facteur K connu près, à la puissance fournie V+.I+. L'énergie électrique correspondante comptée par le compteur 13 est fournie par l'expression:

$$W3 = K \int_0^T (V+.I+) \ dt = \int_0^T (V1.I1) \ dt \qquad (5)$$

Les signaux V- et I- sont traités de la même manière que les signaux V+ et I+. Le signal $\varphi 2$ , déphasé de 120° par rapport à $\varphi 1$, est modulé dans un multiplieur 28 par le signal V-fourni par le circuit 20 et représentatif de la tension sur le conducteur L-. Le signal de sortie du multiplieur 28 est amplifié par un amplificateur 29 qui fournit la tension alternative de sortie V2 déphasée de 120° par rapport à V1. La modulation du signal $\varphi 2$ par la valeur représentative du courant I- fournie par le circuit 22, est réalisée par un multiplieur 30. La sortie du multiplieur 30 est connectée à l'entrée d'une convertisseur tension-courant 31 qui fournit le courant alternatif I2 en phase avec V2. Les circuits 20 et 22, l'amplificateur 29 et le convertisseur 31 sont constitués de manière à ce que la puissance de sortie V2.I2 soit représentative de la puissance (V-).(I-) à laquelle elle est proportionnelle, au facteur K près. L'énergie électrique correspondante comptée par le compteur 13 est fournie par l'expression:

$$W4 = K \int_0^T (V-.I-) \ dt = \int_0^T (V2.I2) \ dt \qquad (6)$$

Pour ne pas perturber le fonctionnement du compteur 13, bien que la valeur V3 ne joue aucun rôle, le courant I3 étant nul, il est préférable de fournir au compteur 13 un signal V3 déphasé de 240° par rapport à V1 et dont l'amplitude est compatible avec l'entrée du compteur. Sur la figure le signal V3 est fourni par un amplificateur 32 recevant en entrée le signal $\varphi 3$ du générateur 23.

La puissance fournie par le convertisseur 12 est donnée par :

$$P1 = V1.I1 + V2.I2 \qquad (7)$$

l'énergie reçue par le compteur est :

$$W5 = K \int_0^T [ (V+.I+) + (V-.I-) ] \ dt = \int_0^T [ (V1.I1)+(V2.I2) ] \ dt \qquad (8)$$

Le facteur K connu est pris en compte lors de la fabrication, du paramétrage ou de la calibration du compteur. La correspondance entre le facteur K connu et la calibration du compteur permet de compter et de visualiser la valeur réelle de l'énergie consommée et exprimée par :

$$W6 = \int_0^T [ (V+.I+)+(V-.I-) ] \ dt = \frac{1}{K} \int_0^T [ (V1.I1) + (V2.I2) ] \ dt \qquad (9)$$

Un circuit d'alimentation électrique 33 fournit les tensions de fonctionnement nécessaires aux circuits électroniques constituant le convertisseur 12. Le circuit d'alimentation électrique 33 peut, par exemple, être alimenté en alternatif ou en courant continu.

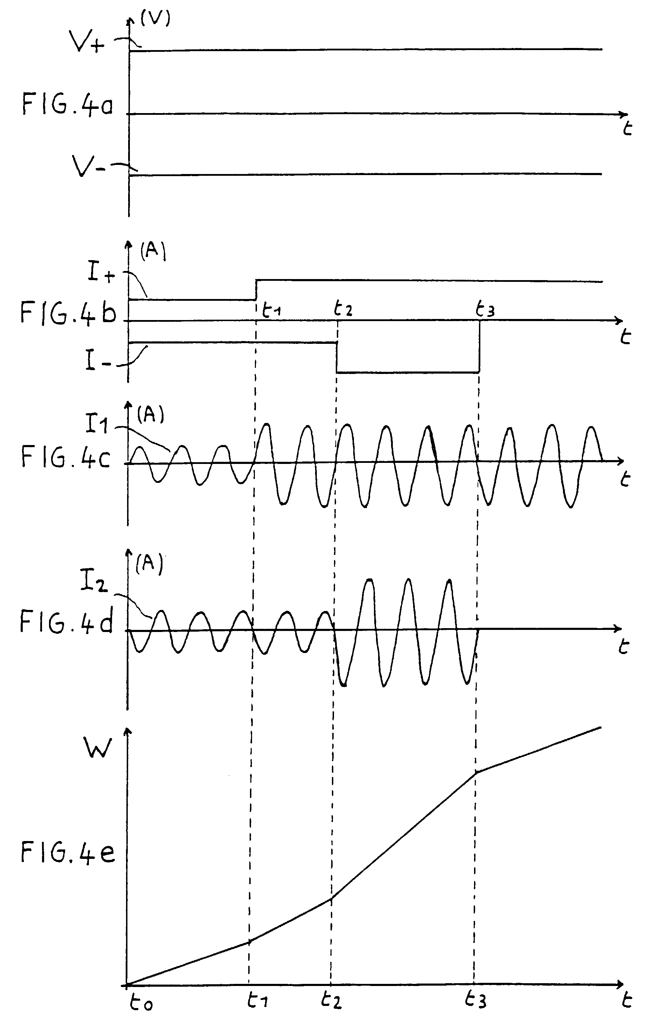

Les figures 4a à 4e illustrent un exemple de variations des valeurs de tension, de courant et d'énergie dans un convertisseur selon la figure 3. Sur les courbes de la figure 4a, les tensions continues V+ et V- sont stables et constantes. Les courbes de la figure 4b montrent les variations de I+ et I-. Le courant I+ prend une première valeur jusqu'à un instant T1. Ensuite, il prend une seconde valeur plus élevée. Le courant I- prend une première valeur jusqu'à un instant t2, puis il change de valeur jusqu'à un instant t3 où il devient nul. La courbe de la figure 4C illustre la forme et les variations de I1. L'amplitude du courant alternatif I1 suit les variations de I+. Sa valeur change à l'instant t1. De la même manière, la courbe de la figure 4d illustre la forme et les variations de I2. L'amplitude de I2 augmente à l'instant t2 et devient nulle en t3. La courbe 4e montre les variations de l'énergie comptée par le compteur. Entre les instants t0 et t1 l'énergie croît en fonction des premières valeurs de I+ et I-. Puis entre les instants t1 et t2 elle croît plus rapidement en fonction de la première valeur I- et de la seconde valeur I+. La croissance est encore plus rapide entre t2 et t3 où elle dépend des secondes valeurs, élevées, de I- et I+. A partir de l'instant t3 la croissance est plus faible, la valeur I- étant réduite à zéro.

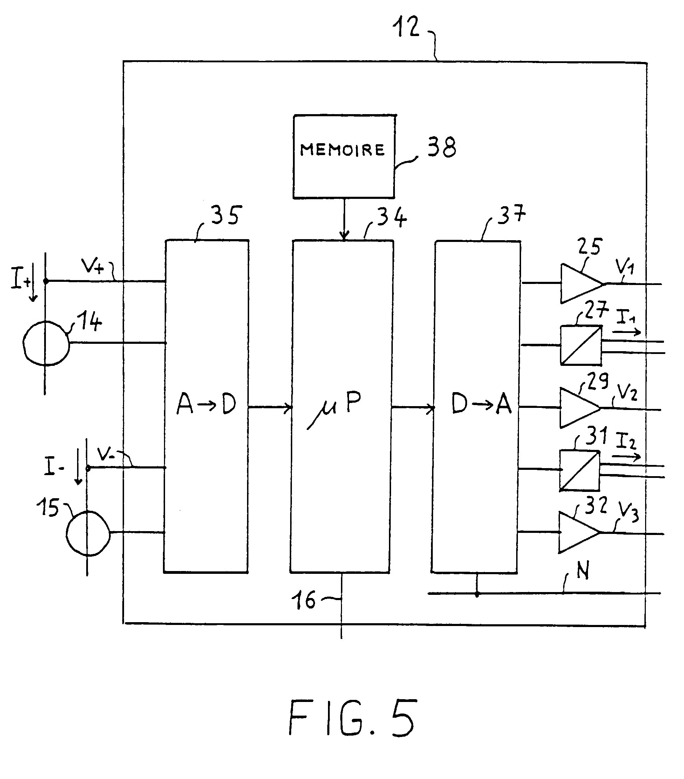

Un autre mode de réalisation d'un convertisseur 12 est représenté à la figure 5. Les multiplieurs 24, 26, 28, 30 et le générateur 23 de la figure 3 sont remplacés par un microprocesseur 34 associé à un convertisseur 35 analogique-digital, à un convertisseur digital-analogique 37 et à une mémoire 38. Les valeurs représentatives des tensions V+ et V- et des courants I+ et I- sont appliquées à l'entrée du convertisseur 35 qui fournit des valeurs numériques d'entrée au microprocesseur. Le microprocesseur fournit au convertisseur 37 des valeurs numériques de sortie représentatives des valeurs analogiques alternatives des tensions V1, V2 et V3 et des courants I1 et I2 telles que V1 et I1 soient des signaux alternatifs, en phase, représentatifs respectivement de V+ et I+, V2 et I2 étant déphasés de 120° par rapport à V1 et étant respectivement représentatifs de V- et I-. V3 est un signal alternatif déphasé de 240° par rapport à V1 et d'amplitude prédéterminée fixe. Comme sur la figure 3, les valeurs représentatives des tensions sont amplifiées par les amplificateurs respectivement 25, 29 et 32 et les valeurs représentatives des courants sont converties par les convertisseurs tension-courant 27 et 31.

Les signaux alternatifs sont générés par le microprocesseur par calcul ou par la lecture de formes pré-enregistrées dans une table stockée dans la mémoire 38. Ces signaux sont modulés par calcul, de préférence directement par les valeurs numériques d'entrée. Le microprocesseur peut, dans une variante de réalisation, calculer une valeur des puissances V+.I+ et V-.I- en fonction des valeurs numériques d'entrée qui lui sont appliquées. Ensuite, le microprocesseur fournit au convertisseur 37 des valeurs numériques de sortie telles que, après conversion par le convertisseur 37, les signaux analogiques alternatifs V1, V2, V3, I1 et I2 soient tels que $V1.I1 = K.V+.I+$ et $V2.I2 = K.V-.I-$, V1 et I1 étant en phase, V2 et I2 déphasés de 120° par rapport à V1 et V3 déphasé de 240° par rapport à V1. Dans ce mode de réalisation, V1 n'est pas représentatif de V+ et I1 de I-, mais le produit V1 et I1 est représentatif du produit V+.I+ et le produit V2 I2 est représentatif du produit V-.I-.

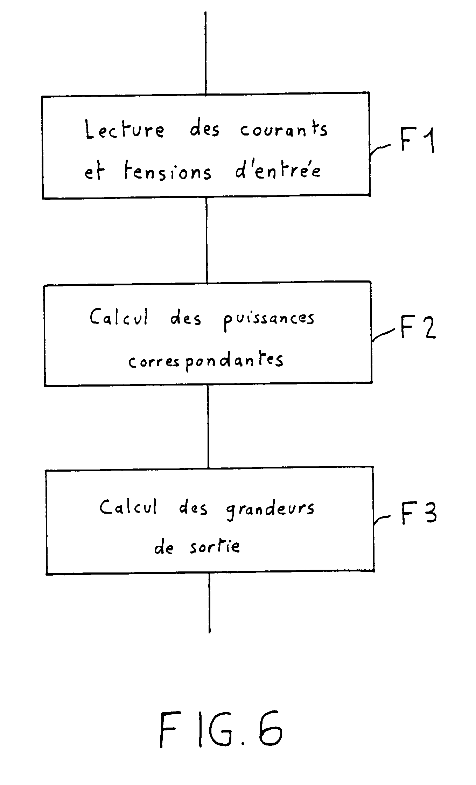

Selon une seconde variante de réalisation, le microprocesseur fournit des tensions alternatives de sortie V1, V2 et V3 d'amplitude prédéterminée indépendante des signaux d'entrée et les amplitudes des courants alternatifs I1 et I2 sont respectivement représentatives des puissances V+.I+ et V-.I- La figure 6 illustre un organigramme partiel permettant de calculer une des grandeurs de sortie, par exemple I1. Après lecture des tensions et courant d'entrée, par exemple V+ et I+ (phase F1), le microprocesseur calcule les puissances correspondantes (phase F2, par exemple V+.I+. Il peut ensuite calculer les grandeurs de sortie (phase F3), par exemple $I1 = K.V+.I+/V1$. Le calcul de I2 s'effectue de manière analogue à partir de la formule $I2 = K.V-.I-/V2$.

Dans tous les cas, l'énergie calculée par le compteur est proportionnelle à l'énergie consommée à mesurer.

Dans les modes de réalisation décrits ci-dessus le compteur standard est un compteur triphasé. Il est possible d'utiliser un compteur monophasé recevant uniquement V1 et I1. Dans ce cas les signaux alternatifs I1 et V1, en phase, doivent être tels que la puissance V1.I1 soit proportionnelle à la puissance fournie à l'installation, soit :

$$V1.I1 = K [(V+.I+) + (V-.I-)] \tag{10}$$

Dans ce cas, le convertisseur 12 doit comporter des moyens de calculer les puissances partielles V+.I+ et V-.I-, de calculer la somme de ces puissances partielles et de fournir des signaux I1 et V1 dont le produit est proportionnel à cette somme. Ceci peut être réalisé sans difficulté avec un convertisseur à microprocesseur, où comme dans les variantes décrites ci-dessus, l'une des valeurs V1 ou I1, est maintenue constante, l'autre, respectivement I1 ou V1, étant alors proportionnelle à la puissance calculée.

Les dispositifs décrits ci-dessus comportent deux entrées de mesure de puissance, une première (V+, I+) correspondant au conducteur L+ et une seconde (V-, I-) correspondant au conducteur L-. Le nombre d'entrées peut être différent, un par exemple pour des alimentations en courant continu à deux conducteurs, trois ou plus dans d'autres cas.

L'invention n'est pas limitée à la mesure de l'énergie électrique consommée par une installation alimentée en courant continu. Elle peut être utilisée de la même manière pour des installations alimentées par des courants déformés ou perturbés, ou par exemple, lorsque la fréquence du courant ou de la tension n'est pas compatible avec les compteurs électriques standards. Les signaux alternatifs φ1 à φ3 sont de préférence générés par un circuit interne au dispositif de comptage, mais pour des raisons économiques ou de comptabilité, ils pourraient être fournis par des circuits externes. Le dispositif de comptage peut être réalisé en différentes technologies par exemple analogiques, numériques ou mixtes. Le traitement de la modulation et le calcul de la puissance peuvent être réalisés par des circuits opérationnels ou par programme si le dispositif comporte un microprocesseur.

Les capteurs de courant peuvent comporter une résistance de mesure associée à un amplificateur isolé galvaniquement entre l'entrée et la sortie. Ils peuvent également comporter des cellules à effet Hall ou des cellules à magnorésistance lorsque les courants à mesurer sont de valeur très élevée.

## Revendications

1. Dispositif de mesure et de comptage de l'énergie électrique consommée par une installation, dispositif comportant des moyens (14, 15) de mesure d'au moins un courant (I+, I-) consommé par l'installation, des moyens de mesure d'au moins une tension associée (V+, V-) appliquée à l'installation, un compteur d'énergie électrique standard (13) fonctionnant en courant alternatif et comportant des entrées de courant (I1-I3) et de tension (V1-V3), dispositif caractérisé en ce qu'il comporte des moyens de conversion (12) connectés entre les moyens de mesure et le compteur standard (13), et comportant des moyens de production de signaux alternatifs de courant,et de tension de sortie (I1-I3, V1-V3) adaptés au compteur standard, la puissance, représentée par les signaux alternatifs de courant et de tension fournis par le convertisseur, étant proportionnelle à la puissance électrique correspondant aux courants et tensions mesurés par les moyens de mesure.

2. Dispositif selon la revendication 1, caractérisé en ce que les moyens de mesure fournissant des premiers couples (V+, I+ ; V-, I-) de signaux de tension et de courant, les moyens de conversion (12) fournissant au compteur (13) des seconds couples (V1, I1 V2, I2 ; V3, I3) de signaux de tension et de courant alternatifs tels, que la puissance correspondant à la somme des produits tension-courant des seconds couples de signaux soit proportionnelle à la puissance correspondant à la somme des produits tension-courant des premiers couples de signaux.

3. Dispositif selon l'une des revendications 1 et 2, caractérisé en ce que les moyens de conversion (12) comportent des moyens (24, 26, 28, 30, 34) de contrôle et de modulation de l'amplitude des signaux alternatifs (I1, I2, V1, V2) de sortie des moyens de conversion en fonction des valeurs des signaux de sortie des moyens de mesure.

4. Dispositif selon l'une des revendications 1 et 2, caractérisé en ce que les moyens de conversion (12) comportent des moyens (34, 38, F3) de contrôle et de modulation de l'amplitude des signaux alternatifs (I1, I2, V1, V2) de sortie des moyens de conversion en fonction de la puissance (V+.I+, V-.I-) associée à au moins un signal de courant et un signal de tension associé fournis par les moyens de mesure.

5. Dispositif selon l'une quelconque des revendications 1 à 4, caractérisé en ce que les moyens de conversion (12) comportent des moyens (25, 29, 32) d'amplification des signaux alternatifs représentatifs des tensions de sortie fournissant des tensions de sortie (V1, V2, V3) d'amplitude compatible avec les niveaux du compteur (13) et des moyens (27, 31) de conversion tension-courant convertissant les signaux alternatifs représentatifs des courants de sortie en courants (I1, I2, I3) compatibles avec les caractéristiques du compteur (13).

6. Dispositif selon l'une quelconque des revendications 1 à 5 caractérisé en ce que les moyens de conversion (12) comportent des moyens (23, 34, 38) de production de signaux alternatifs (Q1, Q2 et Q3) de fréquence compatible avec les caractéristiques-du compteur standard (13).

7. Dispositif selon la revendication 6, caractérisé en ce que lesdits moyens de production de signaux alternatifs fournissent des signaux triphasés, le compteur standard (13) étant un compteur triphasé.

8. Dispositif selon l'une quelconque des revendications précédentes, caractérisé en ce que les moyens de mesure d'au moins un courant sont destinés à mesurer un courant continu et les moyens de mesure d'au moins une tension sont destinés à mesurer une tension continue.

9. Dispositif selon la revendication 8, caractérisé en ce que les moyens de mesure fournissent aux moyens de conversion un premier des premiers couples (V+, I+) et un second (V-, I-) des premiers couples de signaux de tension et de courant , le compteur (13) étant un compteur triphasé, les moyens de conversion (12) fournissant un troisième couple (V1, I1) de signaux alternatifs de tension et de courant dont la puissance (V1.I1) est représentative de la puissance (V+.I+) du premier des premiers couples et un quatrième couple (V2, I2) de signaux alternatifs de tension et de courant, déphasés de 120° par rapport aux signaux de tension et de courant du troisième couple et dont la puissance (V2.I2) est représentative de puissance (V-.I-) du second des premiers couples, le compteur (13) comportant une entrée de courant (I3) forcée à zéro.

10. Dispositif selon l'une quelconque des renvendications 1 à 7, caractérisé en ce que les moyens de mesure d'au moins un courant et les moyens de mesure d'au moins une tension sont destinés à mesurer des grandeurs électriques en courant alternatif de fréquence différente de la fréquence de fonctionnement du compteur électrique.

**Patentansprüche**

1. Meß- und -Zählereinrichtung zur Erfassung des elektrischen Energieverbrauchs einer Installation mit Mitteln (14, 15) zur Messung mindestens eines von der Installation aufgenommenen Stroms (I+, I-), Mitteln zur Messung mindestens einer an die Installation angelegten, zugeordneten Spannung (V+, V-) sowie einem mit Wechselstrom arbeitenden Standard-Elektrizitätszähler (13) mit Strom- (I1-I3) und Spannungseingängen (V1-V3), dadurch gekennzeichnet, daß die Einrichtung zwischen die Meßmittel und den Standardzähler (13) geschaltete Umrichtmittel (12) umfaßt, welche ihrerseits Mittel zur Erzeugung von an den Standardzähler angepaßten Wechselstrom- und Wechselspannungs-Ausgangssignalen (I1-I3, V1-V3) umfassen, wobei die, durch die vom Umrichter gelieferten Wechselstrom- und Wechselspannungssignale abgebildete Leistung proportional zu der elektrischen Leistung ist, die sich aus den durch die Meßmittel gemessenen Strömen und Spannungen ergibt.

2. Einrichtung nach Anspruch 1, dadurch gekennzeichnet, daß die Meßmittel erste Spannungs-Strom-Signalpaare (V+, I+ ; V-, I-) und die Umrichtmittel (12) zweite Wechselspannungs-Wechselstrom-Signalpaare (V1, I1 ; V2, I2 ; V3, I3) an den Zähler (13) liefern, derart daß die der Summe der Spannungs-Strom-Produkte der zweiten Signalpaare entsprechende Leistung der Leistung proportional ist, die sich aus der Summe der Spannungs-Strom-Produkte der ersten Signalpaare ergibt.

3. Einrichtung nach einem der Ansprüche 1 und 2, dadurch gekennzeichnet, daß die Umrichtmittel (12) Mittel (24, 26, 28, 30, 34) zur Steuerung und Modulation der Amplitude der Ausgangswechselsignale (I1, I2, V1, V2) der Umrichtmittel in Abhängigkeit von den Ausgangssignalwerten der Meßmittel umfassen.

4. Einrichtung nach einem der Ansprüche 1 und 2, dadurch gekennzeichnet, daß die Umrichtmittel (12) Mittel (34, 38, F3) zur Steuerung und Modulation der Amplitude der Ausgangswechselsignale (I1, I2, V1, V2) der Umrichtmittel in Abhängigkeit von der Leistung (V+.I+, V-.I-) umfassen, die mindestens einem Strom- und einem Spannungssignal zugeordnet ist, welche von den Meßmitteln geliefert werden.

5. Einrichtung nach irgendeinem der Ansprüche 1 bis 4, dadurch gekennzeichnet, daß die Umrichtmittel (12) Mittel (25, 29, 32) zur Verstärkung der die Ausgangsspannungen abbildenden Wechselsignale umfassen, welche Mittel Ausgangsspannungen (V1, V2, V3) mit einer an die Kennwerte des Zählers (13) angepaßten Amplitude liefern, sowie Spannungs-Strom-Umrichtmittel (27, 31) zur Umwandlung der die Ausgangsströme abbildenden Wechselsignale in an die Kenndaten des Zählers (13) angepaßte Ströme (I1, I2, I3) umfassen.

6. Einrichtung nach einem der Ansprüche 1 bis 5, dadurch gekennzeichnet, daß die Umrichtmittel (12) Mittel (23, 34, 38) zur Erzeugung von Wechselsignalen (Q1, Q2 und Q3) umfassen, deren Frequenz an die Kenndaten des Standardzählers (13) angepaßt ist.

7. Einrichtung nach Anspruch 6, dadurch gekennzeichnet, daß die genannten Mittel zur Erzeugung von Wechselsignalen dreiphasige Signale liefern und der Standardzähler (13) als Dreiphasenzähler ausgebildet ist.

8. Einrichtung nach irgendeinem der vorhergehenden Ansprüche, dadurch gekennzeichnet, daß die Mittel zur Messung mindestens eines Stroms zur Messung eines Gleichstroms dienen, und die Mittel zur Messung mindestens einer Spannung zur Messung einer Gleichspannung dienen.

9. Einrichtung nach Anspruch 8, dadurch gekennzeichnet, daß die Meßmittel bei einer Auslegung des Zählers (13) als Dreiphasenzähler ein erstes (V+, I+) und ein zweites (V-, I-) der ersten Spannungs-Strom-Signalpaare an die Umrichtmittel liefern und die Umrichtmittel (12) ein drittes Wechselspannungs-Wechselstrom-Signalpaar (V1, I1), dessen Leistung (V1.I1) die Leistung (V+.I+) des ersten der ersten Signalpaare abbildet, sowie ein viertes Wechselspannungs-Wechselstrom-Signalpaar (V2, I2) liefern, welches in bezug auf die Spannungs-Strom-Signale des dritten Signalpaars um 120° phasenverschoben ist und dessen Leistung (V2.I2) die Leistung (V-.I-) des zweiten der ersten Signalpaare abbildet, wobei der Zähler (13) einen zwangsweise auf null gesetzten Stromeingang (13) umfaßt.

**10.** Einrichtung nach irgendeinem der Ansprüche 1 bis 7, dadurch gekennzeichnet, daß die Mittel zur Messung mindestens eines Stroms sowie die Mittel zur Messung mindestens einer Spannung dazu dienen, elektrische Wechselgrößen zu messen, deren Frequenz von der Betriebsfrequenz des Elektrizitätszählers abweicht.

**Claims**

**1.** A device for measuring and metering the electrical energy consumed by an installation, a device comprising means (14, 15) for measuring at least one current (I+, I-) consumed by the installation, means for measuring at least one associated voltage (V+, V-) applied to the installation, a standard electrical energy meter (13) operating in alternating current and comprising current inputs (11-13) and voltage inputs (V1-V3), a device characterized in that it comprises means for conversion (12) connected between the means for measuring and the standard meter (13), and comprising means for producing output AC current and voltage signals (11-13, V1-V3) suitable for the standard meter, the power, represented by the AC current and voltage signals supplied by the converter, being proportional to the electrical power corresponding to the currents and voltages measured by the means for measuring.

**2.** The device according to claim 1, characterized in that the means for measuring supply first couples (V+, I+; V-, I-) of voltage and current signals, the means for conversion (12) supplying to the meter (13) second couples (V1, 11, V2, 12; V3, 13) of AC voltage and current signals such that the power corresponding to the sum of the voltage-current products of the second couples of signals is proportional to the power corresponding to the sum of the voltage-current products of the first couples of signals.

**3.** The device according to one of the claims 1 or 2, characterized in that the means for conversion (12) comprise means (24, 26, 28, 30, 34) for monitoring and modulating the amplitude of the AC signals (11, 12, V1, V2) output from the means for conversion in terms of the values of the output signals from the means for measuring.

**4.** The device according to one of the claims 1 or 2, characterized in that the means for conversion (12) comprise means (34, 38, F3) for monitoring and modulating the amplitude of the AC signals (11, 12, V1, V2) output from the means for conversion in terms of the power (V+.I+, V-.I-) associated to at least one current signal and one associated voltage signal supplied by the means for measuring.

**5.** The device according to any one of the claims 1 to 4, characterized in that the means for conversion (12) comprise means (25, 29, 32) for amplifying the AC signals representative of the output voltages supplying output voltages (V1, V2, V3) of compatible amplitude with the levels of the meter (13) and means (27, 31) for voltage-current conversion converting the AC signals representative of the output currents into currents (I1, I2, I3) compatible with the characteristics of the meter (13).

**6.** The device according to any one of the claims 1 to 5, characterized in that the means for conversion (12) comprise means (23, 34, 38) for producing AC signals (Q1, Q2 and Q3) of a frequency compatible with the characteristics of the standard meter (13).

**7.** The device according to claim 6, characterized in that said means for producing AC signals supply three-phase signals, the standard meter (13) being a three-phase meter.

**8.** The device according to any one of the foregoing claims, characterized in that the means for measuring at least one current are designed for measuring a direct current and the means for measuring at least one voltage are designed for measuring a direct voltage.

**9.** The device according to claim 8, characterized in that the means for measuring supply to the means for conversion a first (V+, I+) of the first couples and a second (V-, I-) of the first couples of voltage and current signals, the meter (13) being a three-phase meter, the means for conversion (12) supplying a third couple (V1, I1) of AC voltage and current signals whose power (V1.I1) is representative of the power (V+.I+) of the first of the first couples and a fourth couple (V2, 12) of AC voltage and current signals, with a phase difference of 120° with respect to the voltage and current signals of the third couple and whose power (V2.12) is representative of the power (V-.I-) of the second of the first couples, the meter (13) comprising a current input (13) forced to zero.

**10.** The device according to any one of the claims 1 to 7, characterized in that the means for measuring at least one current and the means for measuring at least one voltage are designed for measuring electrical quantities in alternating current of a frequency different from the operating frequency of the electrical energy meter.

FIG. 1

FIG.2

EP 0 628 828 B1

FIG. 3

FIG.4a

FIG.4b

FIG.4c

FIG.4d

FIG.4e

FIG. 5

Lecture des courants
et tensions d'entrée $\quad$ F1

Calcul des puissances
correspondantes $\quad$ F2

Calcul des grandeurs
de sortie $\quad$ F3

# FIG. 6